Europäisches Patentamt

European Patent Office

Office européen des brevets

(11) Numéro de publication: **0 397 573**
**A1**

## (12) DEMANDE DE BREVET EUROPEEN

(21) Numéro de dépôt: **90401245.7**

(22) Date de dépôt: **10.05.90**

(51) Int. Cl.⁵: **G01R 33/34**

(30) Priorité: **12.05.89 FR 8906285**

(43) Date de publication de la demande:
**14.11.90 Bulletin 90/46**

(84) Etats contractants désignés:
**DE GB NL**

(71) Demandeur: **COMMISSARIAT A L'ENERGIE ATOMIQUE**
**31/33, rue de la Fédération**
**F-75015 Paris(FR)**

(72) Inventeur: **Dufour, Michel**
**13 rue Pierre Sémard**
**F-38000 Grenoble(FR)**
Inventeur: **Jeandey, Christian**
**Chemin Fiancey, Le Muret**
**F-38210 Saint Egreve(FR)**
Inventeur: **Rustique, Jacques**
**34 rue de Pacalaire**
**F-38170 Seyssinet(FR)**

(74) Mandataire: **Mongrédien, André et al**
**c/o BREVATOME 25, rue de Ponthieu**
**F-75008 Paris(FR)**

(54) **Résonateur parallélépipèdique rectangulaire pour la création d'un champ magnétique RF.**

(57) Résonateur parallélépipèdique rectangulaire pour la création d'un champ magnétique comprenant une ligne conductrice fermée supportée par une feuille isolante et amagnétique (12) et composée de conducteurs plats (16, 17) reliés par des connexions de liaison (18) et d'au moins deux condensateurs (24) reliés en série avec les conducteurs plats (16, 17). La ligne constitue un bobinage réparti sur quatre faces du parallélépipède.

Application à l'imagerie RMN.

FIG. 2

EP 0 397 573 A1

La présente invention a pour objet un résonateur parallélépipèdique rectangulaire pour la création d'un champ magnétique de radio fréquence (RF). Elle s'applique notamment à l'imagerie par résonance magnétique nucléaire (RMN) mais aussi à la spectroscopie RMN et de manière plus générale à tous les dispositifs nécessitant un champ magnétique de haute fréquence, c'est-à-dire comprise dans une gamme allant de quelques mégahertz à quelques dizaines de mégahertz.

Des résonateurs pour la création d'un champ magnétique doté d'une fréquence contenue dans cette gamme sont connus dans le domaine des imageurs RMN où ils sont communément appelés antennes. Ces résonateurs sont du type L, C c'est-à-dire qu'ils comportent un bobinage et au moins un condensateur.

La méthode d'imagerie RMN utilise la propriété de résonance magnétique nucléaire de certains noyaux présents dans le corps humain, essentiellement les protons répartis dans tout l'organisme, et quelques noyaux d'intérêt biologique mais en abondance beaucoup moins grande tels que le phosphore ($^{31}$P), le potassium ($^{39}$K), le sodium ($^{23}$Na).

Un imageur RMN comprend des moyens pour créer un champ magnétique Bo permanent, intense ($5.10^{-2}$ à 5 T) et homogène. Il comprend en outre un résonateur (antenne) pour créer un champ magnétique tournant de radio fréquence B1 perpendiculaire à la direction du champ magnétique permanent Bo.

Les images sont obtenues en faisant résonner les noyaux d'hydrogène ou protons, contenus dans les tissus biologiques. Cette résonance est possible parce que chaque proton se comporte comme un microscopique aimant. En effet, lorsque l'on applique le champ statique Bo, les spins nucléaires s'orientent tous de telle sorte que la résultante macroscopique de leurs moments magnétiques soit située parallèlement à l'axe du champ. Lorsqu'on applique en plus le champ tournant à une fréquence quelconque, il ne se passe rien. Mais si cette fréquence est choisie égale ou très voisine de $f_o$, telle que $f_o = \gamma B_o$, formule dans laquelle $\gamma$ est une constante physique caractéristique des noyaux que l'on veut mettre en résonance, le couplage des spins et du champ tournant atteint est tel que ceux-ci entrent en résonance et sont animés d'un mouvement de précession, en phase, autour de la direction de Bo.

Le signal de résonance détecté est proportionnel à l'aimantation des noyaux placés dans le champ magnétique Bo de polarisation. L'observation du phénomène de résonance requiert la présence d'un champ magnétique élevé (de quelques 0,1 à quelques teslas) et de très grande uniformité dans tout le volume à imager.

Le champ magnétique tournant radiofréquence B1 est en fait un champ sinusoïdal ; seule une de ses composantes tournantes dans le plan perpendiculaire à Bo est utile à l'expérience. Il doit être homogène et sa zone d'homogénéité doit coïncider avec la zone d'homogénéité du champ Bo.

De manière connue, le champ Bo est créé par un aimant permanent et le résonateur à l'origine du champ B1 est situé à l'intérieur de l'entrefer de cet aimant permanent.

Diverses publications donnent la description de différents types de résonateurs connus. On peut citer par exemple l'article de D.I. Hoult paru dans la revue Progress in NMR Spectroscopy, (1978), vol. 12, p.41-77, ou l'article W. Alderman et al "An efficient decoupler coil design which reduces heating in conductive samples in superconducting spectrometers" paru dans Journal of Magnetic Resonance (1979), 36, p.447-451 ou encore l'article de C.E. Hayes et al "An efficient, highly homogeneous radiofrequency coil for whole body NMR imaging at 1,5 T" paru dans Journal of Magnetic Resonance (1985), 63, p.622-628.

Tous les résonateurs décrits dans ces articles sont cylindriques. L'article de R.C. Samaratunga et al, "Resonator coils for magnetic resonance imaging at 6 MHz" paru dans la revue Medical Physics, March/April 1988, 15(2), p.235-240 décrit quant à lui, un résonateur de type parallélépipèdique rectangulaire.

Mais ces résonateurs, conçus pour être utilisés dans des imageurs où le champ Bo est horizontal (c'est-à-dire traversant le patient des pieds à la tête), ne sont pas adaptés à un imageur utilisant un système d'aimants permanents tels que décrits dans la demande de brevet français n° 87 02851 du 3 mars 1987 par exemple, et présentant un champ magnétique Bo vertical. L'entrefer d'un tel système d'aimants forme un tunnel parallélépipèdique rectangulaire. Le plan horizontal est défini comme étant le plan d'introduction du patient dans l'imageur RMN, le champ magnétique vertical le traversant du dos vers la poitrine.

Le but de la présente invention est de fournir un résonateur particulièrement adapté à un imageur RMN dans lequel le champ magnétique permanent est vertical. De plus, un résonateur conforme à l'invention est très maniable : son montage et son démontage dans le tunnel de l'imageur (entrefer de l'aimant permanent) sont aisés.

De façon plus précise, la présente invention concerne un résonateur parallélépipèdique rectangulaire pour la création d'un champ magnétique selon une direction X ou Y d'un repère XYZ excité inductivement. Ce résonateur comprend, sur quatre faces du parallélépipède, une ligne conductrice fermée supportée par une feuille isolante, amagnétique et composée :

- d'un nombre pair, au moins égal à six, de conducteurs plats répartis en nombre égal dans une direction perpendiculaire à celle du champ magnétique sur deux premières faces en regard parallèles au plan XY,
- des connexions de liaison reliant chaque conducteur plat d'une des premières faces à deux conducteurs plats de l'autre des premières faces de façon à réaliser un bobinage, ces connexions parcourant deux faces en regard parallèles au plan XZ,
- d'au moins deux condensateurs, chacun de ces condensateurs étant relié en série avec deux conducteurs plats.

L'emploi des conducteurs plats permet un encombrement réduit. Le résonateur présente des parois minces s'adaptant parfaitement à un tunnel d'imageur RMN.

La répartition de la capacité résonante en plusieurs condensateurs espacés permet d'éviter la présence de zones de champ électrique intense à l'intérieur du résonateur.

Dans une variante de réalisation, les connexions d'un résonateur conforme à l'invention sont regroupées aux extrémités du parallélépipède.

Lorsque le champ permanent Bo est vertical (dans la direction Z), on peut définir deux directions perpendiculaires entre elles et à la direction de Bo. Une de ces directions est qualifiée de longitudinale ; elle correspond à la direction X; l'autre est qualifiée de transversale ; elle correspond à la direction Y.

Un résonateur conforme à l'invention permet donc l'introduction d'un patient dans un imageur RMN selon la direction longitudinale.

Dans une variante de réalisation d'un résonateur conforme à l'invention, les conducteurs plats présentent des largeurs différentes.

Selon un mode de réalisation particulier, les connexions de liaison sont des conducteurs plats. Ainsi, tout le bobinage peut être réalisé à partir de conducteurs plats. Seule la largeur des conducteurs change suivant leur emplacement dans le résonateur.

De façon générale, la section de ces conducteurs (conducteurs plats et connexions de liaison) est d'autant plus large qu'ils sont situés près du centre du parallélépipède pour améliorer l'homogénéité du champ magnétique B1.

D'autres caractéristiques et avantages de l'invention apparaîtront mieux après la description qui suit donnée à titre explicatif et nullement limitatif. Cette description se réfère à des dessins annexés sur lesquels :

- la figure 1 représente schématiquement un système connu d'aimants fournissant un champ magnétique permanent vertical,
- la figure 2 représente schématiquement une première variante de réalisation d'un résonateur conforme à l'invention,
- la figure 3 représente schématiquement une seconde variante de réalisation d'un résonateur conforme à l'invention,
- la figure 4 représente schématiquement une troisième variante de realisation d'un résonateur selon l'invention.

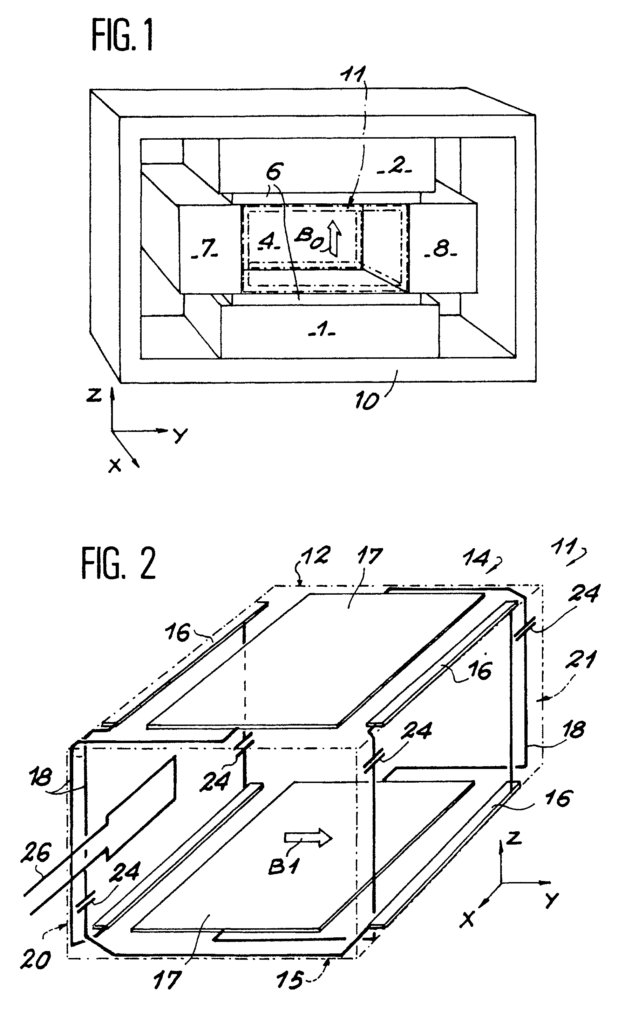

La figure 1 représente schématiquement un système connu d'aimants fournissant un champ magnétique permanent Bo vertical. Ce système fait partie intégrante d'un imageur RMN ; la direction verticale est considérée par rapport au plan dit "frontal" d'introduction du patient. Cette direction, indiquée par une flèche sur la figure, est parallèle à l'axe Z d'un repère marquant les trois directions de l'espace X, Y, Z, la direction X correspondant à la direction d'introduction du patient.

Le système est constitué de deux aimants principaux 1 et 2, disposés face à face parallèlement au plan XY et de même sens d'aimantation et de deux aimants permanents additionnels 7, 8 formant les parois latérales du tunnel 4 et de sens d'aimantation opposé à celui des deux aimants principaux. L'uniformité du champ magnétique Bo est assurée dans l'entrefer ou tunnel 4 par deux pièces polaires 6 en matériau perméable magnétique.

L'ensemble est maintenu dans une carcasse métallique 10 qui permet aux lignes de champ de se refermer.

On constate donc que dans ce système le tunnel est parallélépipèdique rectangulaire.

Le résonateur ou antenne est placé à l'intérieur du tunnel 4 : on n'en voit qu'une partie 11 sur cette représentation.

La figure 2 représente schématiquement une première variante de réalisation d'un résonateur selon l'invention pour un champ magnétique B1 transversal (c'est-à-dire dans la direction Y).

Ce résonateur est un montage L, C : il comporte un bobinage et des condensateurs. Il est de forme parallélépipèdique rectangulaire de manière à épouser les formes du tunnel 4 (figure 1).

Un support isolant et amagnétique 12 sous forme de feuille souple, supporte, sur deux premières faces 14, 15 en regard, parallèles au plan XY, des conducteurs plats 16, 17. Ces conducteurs plats 16, 17 sont ici au nombre de six répartis également sur les deux faces 14, 15.

Les conducteurs plats 16, 17 sont par exemple des feuilles de cuivre d'épaisseur supérieure à deux fois l'épaisseur de peau à la fréquence d'utilisation.

Des connexions de liaison 18 relient chaque conducteur plat 16, 17 d'une des faces 14, 15 à deux conducteurs plats 16, 17 de l'autre des faces 14, 15 de manière à réaliser un bobinage. Ces connexions de liaison 18 parcourent deux autres faces 20, 21 en regard du support 12, parallèles au plan XZ et perpendiculaires aux deux premières faces 14, 15. Elles sont réparties aux extrémités du parallélépipède, à proximité des arêtes pour obtenir une construction solénoïdale compte tenu du fait que les conducteurs plats sont dans la direction X. Le centre des faces 20, 21 étant libre, un accès au patient par ces faces peut alors être possible à condition que l'imageur présente lui-même un accès latéral.

Les connexions de liaison 18 sont elles aussi réalisées par des conducteurs plats par exemple en cuivre d'épaisseur supérieur à deux fois l'épaisseur de peau à la fréquence d'utilisation. Dans cette variante, les conducteurs plats présentent trois largeurs qui peuvent être différentes : les conducteurs 17 sont les plus larges et occupent la majeure partie de la surface des faces 14 et 15 ; les conducteurs 16 sont moins larges que les précédents et occupent les bords des surfaces 14 et 15 ; enfin les connexions de liaison qui serpentent sur les faces 14, 15, 20, 21 sont les moins larges.

Les différentes largeurs des conducteurs plats 16, 17, 18 sont réalisées de manière à obtenir d'abord la plus grande homogénéité possible du champ B1 à l'intérieur du résonateur, pour un gabarit de résonateur donné, puis un résistance du bobinage la plus faible possible.

Les condensateurs 24, au nombre de quatre dans cette réalisation, sont reliés en série avec les conducteurs plats 16, 17. Ces condensateurs sont répartis sur les arêtes du parallélépipède ; ils sont sensiblement équidistants, et leur position est ajustée de manière à obtenir le meilleur coefficient de surtension dans le résonateur et une même chute de potentiel entre eux.

Le bobinage muni des condensateurs reliés en série constitue une ligne conductrice fermée.

L'introduction de l'énergie électromagnétique dans le résonateur se fait par couplage avec une spire d'injection 26 reliée à une source d'alimentation électrique (non représentée). Cette spire est toujours située sur une des deux faces du parallélépipède perpendiculaire à la direction du champ B1.

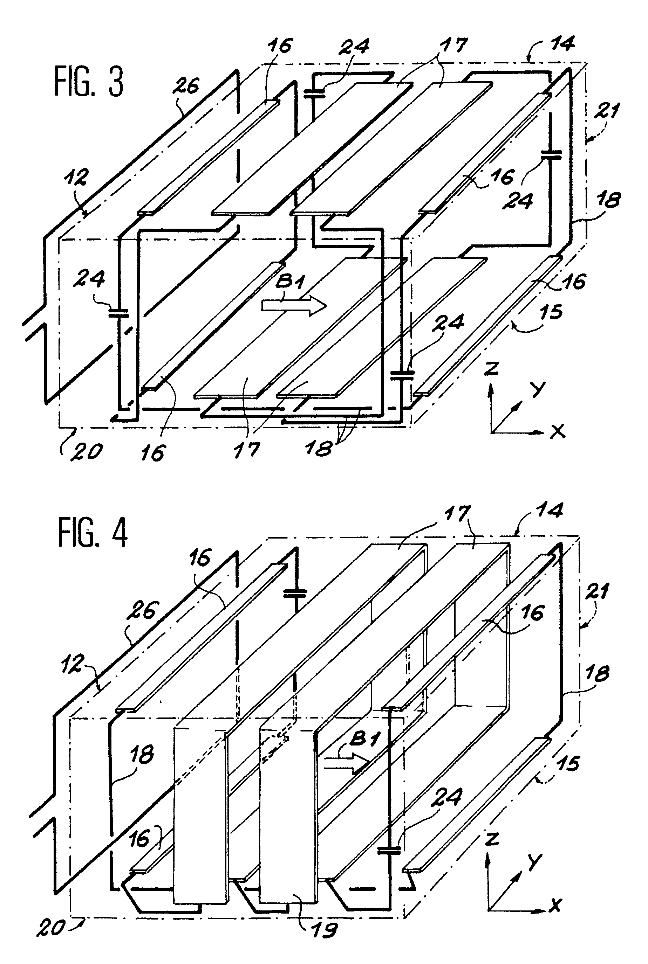

La figure 3 représente schématiquement un résonateur longitudinal, c'est-à-dire que le champ B1 créé s'étend longitudinalement (dans la direction X d'introduction du patient). Pour permettre l'introduction d'un patient, la spire d'injection 26 est dans ce cas agrandie et éventuellement éloignée selon l'axe X de façon à préserver l'adaptation d'impédance entre le résonateur et la source d'énergie.

Dans cet exemple de réalisation, le résonateur comporte quatre spires au lieu de trois dans l'exemple précédent. Les conducteurs plats 16, 17 présentent différentes largeurs de manière à obtenir une plus grande homogénéité du champ B1 à l'intérieur du résonateur. Les conducteurs plats 17 sont par exemple cinq fois plus larges que les conducteurs plats 16.

La figure 4 représente schématiquement une variante de réalisation d'un résonateur selon l'invention. Ce résonateur est longitudinal. Quatre connexions de liaison 19 plates et larges sont réparties en nombre égal sur les faces 20 et 21 du résonateur. Elles sont reliées aux autres conducteurs plats 16, 17 situés sur les faces 14, 15 de manière à réaliser avec les connexions de liaison 18 un bobinage à quatre spires. Deux condensateurs 24 sont reliés en série avec des conducteurs plats. Il sont disposés sur deux connexions de liaison situées sur deux arêtes opposées du parallélépipède.

Dans cet exemple, les connexions de liaison 18 sont réalisées par des conducteurs plats : on distingue donc des conducteurs plats de différentes largeurs adaptées de manière à obtenir la plus grande homogénéité possible du champ magnétique B1. Les conducteurs plats 19 représentés sur la figure 4, ont la même largeur que les conducteurs 17, mais il peut en être autrement.

Dans cette variante, des conducteurs plats bordent chaque paroi du tunnel de l'imageur RMN.

Dans tous les exemples de réalisation, les valeurs respectives de l'auto induction et de la capacité du résonateur résultent d'un compromis entre diverses exigences contradictoires. Les valeurs L et C de l'auto induction et de la capacité sont liées par la relation bien connue $LC\omega_o^2 = 1$ où $\omega_o$ est la pulsation de résonance du résonateur fixée par la valeur du champ magnétique permanent Bo.

L doit être choisie la plus grande possible, pour obtenir un champ magnétique B1 intense, sans pour autant que C soit trop petite car dans ce cas, le rssonateur est très sensible aux capacités parasites.

Pour chaque application particulière, le choix de L et d'une configuration géométrique du résonateur (longitudinal ou tansversal) fixe le nombre de spires et la variante de réalisation la meilleure.

On peut citer, à titre d'exemple, un nombre de spires compris entre 1 et 10 pour un résonateur fonctionnant à 10 MHz et de largeur 50 cm, de longueur 50 cm et de hauteur 50 cm.

Le coefficient de qualité d'un résonateur conforme à l'invention de dimensions 100 x 170 x 200 mm$^3$ est supérieur à 200 dans un tunnel d'imageur et avoisine 350 en dehors. Son rendement est d'environ 830 mG/$\sqrt{W}$ à l'intérieur d'un tunnel et 1250 mG/$\sqrt{W}$ à l'extérieur de l'imageur.

## Revendications

1. Résonateur parallélépipèdique rectangulaire pour la création selon une direction X ou Y d'un repère XYZ d'un champ magnétique excité inductivement, caractérisé en ce qu'il comprend, sur quatre faces (14, 15, 20, 21) du parallélépipède une ligne conductrice fermée supportée par une feuille isolante et amagnétique (12) composée :
- d'un nombre pair, au moins égal à six, de conducteurs plats (16, 17) répartis en nombre égal dans une direction perpendiculaire au champ magnétique sur deux premières faces (14, 15) en regard parallèles au plan XY,
- des connexions de liaison (18, 19) reliant chaque conducteur plat d'une des premières faces (14, 15) à deux conducteurs plats de l'autre des premières faces (14, 15) de façon à réaliser un bobinage, ces connexions (18) parcourant deux faces (20, 21) en regard parallèles au plan XZ,
- d'au moins deux condensateurs (24), chacun de ces condensateurs (24) étant relié en série avec deux conducteurs plats (16, 17).

2. Résonateur selon la revendication 1, caractérisé en ce que les connexions de liaison (18) sont regroupées aux extrémités du parallélépipède.

3. Résonateur selon la revendication 1, caractérisé en ce que les conducteurs plats (16, 17) présentent différentes largeurs.

4. Résonateur selon la revendication 1, caractérisé en ce que les connexions de liaison (18, 19) sont des conducteurs plats.

5. Résonateur selon la revendication 4, caractérisé en ce que les connexions de liaison présentent différentes largeurs.

# FIG. 1

# FIG. 2

FIG. 3

FIG. 4

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A,D | MEDICAL PHYSICS, vol. 15, no. 2, mars/avril 1988, pages 235-240, Am. Assoc. Phys. Med., New York, US; R.C. SAMARATUNGA et al.: "Resonator coils for magnetic resonance imaging at 6 MHz" * Section III.B; figure 4 * | 1 | G 01 R   33/34 |
| A | US-A-4 751 464  (J.F. BRIDGES) * Colonne 2, ligne 41 - colonne 3, ligne 57; figures 1,3,6,10 * | 1 | |
| A | US-A-4 231 008  (G.J. KRUEGER) * Colonne 1, ligne 56 - colonne 2, ligne 50; figures 1,4,5 * & FR-A-2 411 478 | 1 | |
| A | EP-A-0 073 375  (SIEMENS AG) * Page 12, ligne 10 - page 13, ligne 19; figures 2,4 * | 1 | |
| A | EP-A-0 217 520  (RESONEX, INC.) * Colonne 3, lignes 3-10; figure 1 * | 1 | DOMAINES TECHNIQUES RECHERCHES (Int. Cl.5) |
| A | EP-A-0 257 782  (PICKER INTERNATIONAL, INC.) * Colonne 1, ligne 19 - colonne 3, ligne 13 * | 1 | G 01 N G 01 R H 01 P |

Le présent rapport a été établi pour toutes les revendications

| Lieu de la recherche | Date d'achèvement de la recherche | Examinateur |
|---|---|---|
| LA HAYE | 27-08-1990 | HORAK G.I. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
...............................................................
& : membre de la même famille, document correspondant

EPO FORM 1503 03.82 (P0402)